Europäisches Patentamt

European Patent Office

Office européen des brevets

(19)

(11) **EP 1 211 806 A1**

(12) **EUROPEAN PATENT APPLICATION**

(43) Date of publication:
**05.06.2002 Bulletin 2002/23**

(51) Int Cl.$^7$: **H03H 17/04**

(21) Application number: **01000566.8**

(22) Date of filing: **24.10.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **24.10.2000 US 242454**

(71) Applicant: **Texas Instruments Incorporated Dallas, Texas 75251 (US)**

(72) Inventor: **Wang, Minsheng**
**TX 75025, Plano (US)**

(74) Representative: **Holt, Michael et al**
**Texas Instruments Ltd.,**
**EPD MS/13,**
**800 Pavilion Drive**
**Northampton Business Park,**
**Northampton NN4 7YL (GB)**

(54) **A parallel implementation for digital infinite impulse response filter**

(57) An IIR filter implementation which provides equivalent results to prior art IIR filters, yet operates about twice as fast as the prior art IIR filters, or requires about half the gate count of the prior art IIR filters and reduced semiconductor area as compared to prior art IIR filters for equivalent speed of operation. An implementation of a high order IIR filter in accordance with one embodiment of the present invention involves the parallel structure of the second-order IIR filters, therefore the filter operates twice as fast as the prior art filter. In accordance with a second embodiment of the invention, low order filters of the same order are reused (used on a time-sharing basis), thereby requiring only a single IIR filter for each order utilized on a time sharing basis, thereby further reducing the number of gates and semiconductor area required.

FIG. 2

EP 1 211 806 A1

**Description**

FIELD OF THE INVENTION

This invention relates generally to digital filters and, more particularly, to a novel implementation for an infinite impulse response (IIR) filter.

BRIEF DESCRIPTION OF THE PRIOR ART

Digital filters are well known in the prior art. Such filters receive sampled digital signals and transmit a sampled waveform therethrough. The waveform transmitted by the digital filter is determined by coefficients operating on portions of the transmitted digital signal. A typical prior art digital filter has a plurality of serially connected delay components with outputs of each delay component transmitted both to the succeeding delay component and to a coefficient addition component, the coefficient addition component adding the output from the delay component applied thereto by a weighting factor derived from a transform function. The outputs of the coefficient addition components are applied to the output terminal of the digital filter to provide the filter output signal. Accordingly, an input signal, after an appropriate delay, is filtered according to the coefficient addition components with the resulting signal being applied to the digital filter output.

Digital filters are classified as infinite impulse response (IIR) filters and finite impulse response filters (FIR). The difference is that the transfer function of the IIR is in both the denominator and numerator whereas, for the FIR, the transfer function is in the numerator.

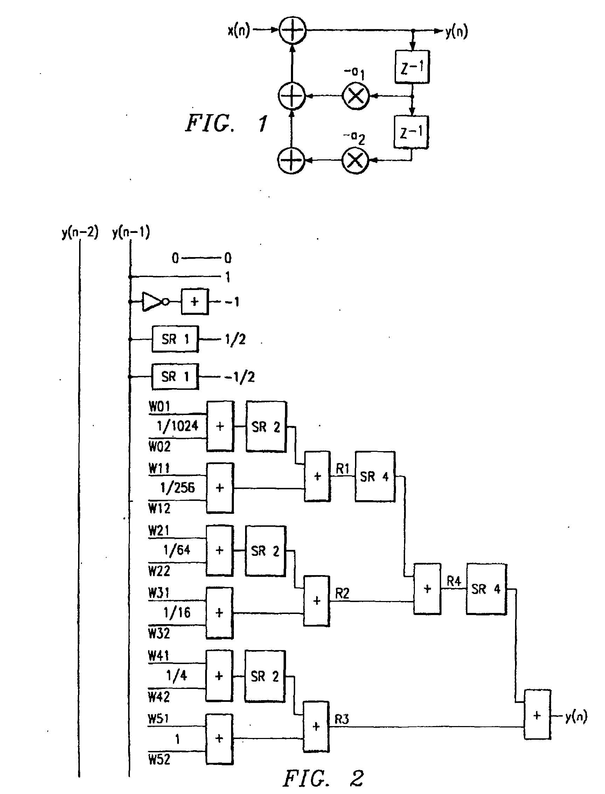

A typical prior art register level implementation for a second-order IIR filter is shown in FIGURE 1 and operates in accordance with the equation: $H(z) = 1/(1 + a_1 z^{-1} + a_2 z^{-2})$, where $H(z) = = Y(z)/X(z)$ is the transfer function of the system and $a_1$ and $a_2$ are multiplication coefficients. The term $z^{-1}$ represents a register unit (such as, for example, a D flip-flop) to store the result of the previous calculation and provide a delay.

With reference to FIGURE 1, the major computation is due to the two multiplications, $-a_1 y(n - 1)$ and $-a_2 y(n - 2)$. With the help of coefficient encoding, known as canonic signed digits (CSD), the multiplications can be performed in shift and addition. For example, binary 0.011 (3/8) is equivalent to binary 0.1 (1/2) minus binary 0.001 (1/8), therefore multiplication of $y(n - 1)$ by binary 0.011 can be performed by one shift-right (SR) minus three shift-right of $y(n - 1)$. Also, nested multiplication (described in a Doctoral Thesis by B. P. Brandt entitled "Oversampled Analog-to-Digital Conversion", Stanford University, CA, 1991, the contents of which are incorporated herein by reference) can be used to reduce the round-off noise. The above example of multiplication by binary 0.011 (3/8) can be alternatively performed by subtracting $y(n - 1)$ by its two right-shift and then one right-shift of the residue, since $(1/2)y(n - 1) - (1/8)y(n -$

$1) = (1/2)(y(n - 1) - (1/4)y(n - 1))$. The advantage of postponing the right-shift to the end is to reduce the round-off noise.

The coefficients $a_1$ and $a_2$ must be realized precisely and accurately for IIR filters in order to obtain a good frequency response without limit-cycle effect. The existing implementation using nested multiplication and interleaving is for the purpose of minimizing the quantization noise and to eliminate the limit-cycle effect. The following example illustrates the existing techniques using the transfer function equation set forth above.

Assume $-a_1 = 1 + 1/512 + 1/1024$ and $-a_2 = 1/16 + 1/256$, then the following four steps calculate $-a_1 y(n - 1) - a_2 y(n - 2) = y(n)$ in accordance with the above transfer function equation:

$$\text{Step 1: } r1 = y(n - 1) + SR(y(n - 1),1);$$

$$\text{Step 2: } r2 = y(n - 2) + SR(r1,1);$$

$$\text{Step 3: } r3 = y(n - 2) + SR(r2,4);$$

$$\text{Step 4: } r4 = y(n - 1) + SR(r3,4);$$

where SR = shift right of the first argument by the amount defined in the second argument, and r1, r2, r3 and r4 are the intermediate result, i.e., the partial summation.

Step 1 uses nested multiplication to calculate (1 + 1/2) for 1/512 + 1/1024 in $-a_1$. Step 2 adds 1/256 from $-a_2$ to the result from step 1. Step 3 adds 1/16 from $-a_2$ to the result from step 2. Step 4 adds 1 from $-a_1$ to the prior result (the result of step 3) and obtains the final result. It can be seen that the partial multiplication is performed interleavedly from the smallest coefficient between $-a_1$ and $-a_2$ to the largest coefficient. Also, nested multiplication is employed to reduce the quantization noise. It should be noted that the above described implementation operates in an inferior manner for high speed applications because of the data dependence of the intermediate result. In Synopsys synthesis, a long critical path is observed from the input to the output, which inevitably slows down the computation. For the simple coefficients $a_1$ and $a_2$ in the above example, it takes four addition cycles to obtain the final result. For the practical filter, it usually takes more than ten addition cycles to obtain the result, which limits this technique to high-speed applications.

SUMMARY OF THE INVENTION

In accordance with the present invention, there is provided an IIR filter implementation which provides equivalent results to prior art IIR filters, yet operates at least twice as fast as prior art IIR filters, or requires about half the gate count (i.e., silicon area) of the prior art IIR filters for approximately equal speed of operation. A parallel implementation of a second-order IIR filter in accordance with a first embodiment of the invention operates faster than the conventional serial implementation of the same second-order IIR filter. In accordance with the second embodiment of the invention, a high order filter is implemented using a single lower order filter on a time sharing basis, thereby reducing the number of gates and semiconductor area required.

BRIEF DESCRIPTION OF THE DRAWING

For a more complete understanding of the present invention, and the advantages thereof, reference is now made to the following detailed description of certain particular and illustrative embodiments and the features and aspects thereof, by way of example only, and with reference to the figures of the accompanying drawings in which:

FIGURE 1 is a block diagram of a typical prior art second order IIR filter;
FIGURE 2 is a block diagram of a parallel structure IIR filter;
FIGURE 3 is a block diagram of an implementation of a high order (seventh order) IIR filter using one or more lower order IIR filters (three second order and one first order IIR filters for the seventh order filter) in accorance with the prior art;
FIGURE 4 is a block diagram showing an implementation of the IIR filter of FIGURE 3 using a single second order IIR filter which is reused on a time-sharing basis preceded by a decoder in accordance with a second embodiment of the invention;
FIGURE 5 is a circuit diagram showing the use of the circuit of FIGURE 2;
FIGURE 6 is a comparison of the performance of the impulse response between the filter in accordance with the present invention and the prior art with the bottom plot showing the low frequency region from which the subject implementation is shown to be closer to ideal response;
FIGURE 7 shows the frequency response for a single tone using the filter; and
FIGURE 8 shows the frequency response of a discrete multi-tone.

DESCRIPTION OF THE PREFERRED EMBODIMENT

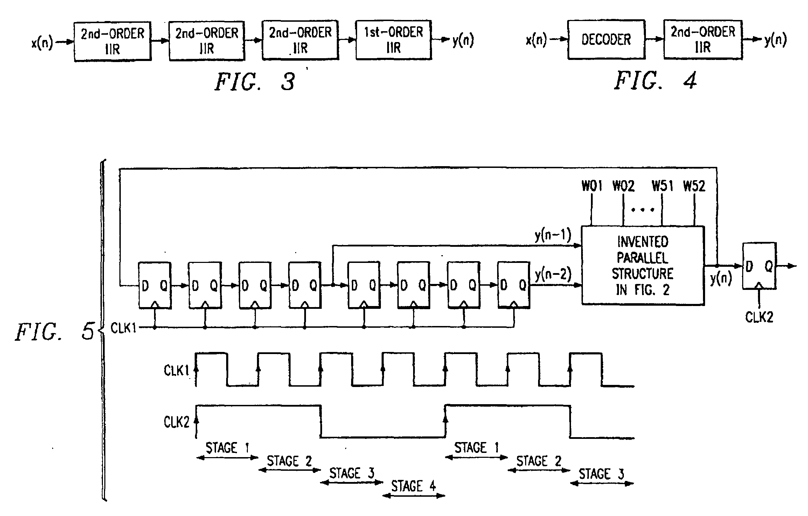

A parallel structure of the invention is shown in FIGURE 2. In this embodiment, the adders from the top to the bottom on the left-most column bear different weights varying from 1/1024 to 1 for the two-input pairs $W_i1, W_i2$, where i = 0,1,...5. Depending upon the actual filter coefficients, the two-input $W_i1W_i2$ is A times y(n - 1) and y(n - 2), respectively, with A taking values from {0,1, - 1,1/2,-1/2}, as shown on the left-top of FIGURE 2. For example, the coefficients $-a_1$ = 1 - 1/4 + 1/16 - 1/64 + 1/512 + 1/1024 and $-a_2$ = 1 - 1/16 + 1/64 - 1/256 corresponding to the following setting:

$$W01 = y(n - 1);$$

$$W02 = zero;$$

$$W11 = SR(y(n - 1), 1);$$

$$W12 = y(n - 2);$$

$$W21 = -y(n - 1);$$

$$W22 = -y(n - 2);$$

$$W31 = y(n - 1) ;$$

$$W32 = y(n - 2)$$

$$W41 = -y(n - 1);$$

$$W42 = zero;$$

$$W51 = y(n - 1)$$

$$W52 = -y(n - 2).$$

It takes four clock-cycles to obtain y(n) with the novel parallel scheme, one clock-cycle for each column of adder as shown in FIGURE 2, as compared to nine clock cycles in the prior art. Another advantage for the scheme of the present invention is that the number of clock-cycle required for computing y(n) is irrelevant to the coefficients, while the number of clock-cycle of the prior art is proportional to the complexity of the coefficients.

In addition to being much faster than the prior art, the parallel structure of FIGURE 2 is also ideal for "programmable" coefficients. The hardware structure depicted in FIGURE 2 can perform as different IIR filters, with inputs having different settings. This is particularly useful for high-order IIR filters.

Assuming implementation of a seventh-order IIR filter running at a clock rate of clk, this filter is comprised of three second-order and one first-order IIR filters as shown in FIGURE 3. By using the scheme in accordance with the present invention, the filter can be run at a clock rate of four times clk. Therefore, the seventh-order filter is now implemented by only one second order filter preceded by a decoder as shown in FIGURE 4. Within one clk, the decoder sequentially sets the values of the Wi1,Wi2, i = 0, 1, ., 5 to the four cascaded filter coefficients. Therefore, the seventh-order filter is implemented by a second order filter on a time sharing basis. A seventh-order filter is synthesized in accordance with the present invention with an area reduction of fifty percent. It should be understood that the seventh order filter can also be synthesized reusing a second order filter on a time sharing basis in the manner discussed with reference to FIGURE 4 and one first order filter.

With reference to FIGURE 5, there is shown the circuit of FIGURE 4 with input to and output therefrom as well as the timing diagram therefor. The output y(n) is fed back to the input of eight cascaded D flip flops which are clocked in accordance with clk1 such that the signal y(n) is transferred from D flip flop to D flip flop for each clk1 signal. The y(n) signal is delayed by four clk1 signals whereupon it is fed back to the circuit of FIGURE 2 as signal y(n-1) from the fourth of the cascaded D flip flops. Also, the signal is delayed by eight clk signals whereupon it is fed back to the circuit of FIGURE 2 as signal y(n-2) from the eighth of the cascaded D flip flops. Meanwhile, the output D flip flop is clocked by clk2 which operates at one fourth the speed of clk1 to provide an output from the D flip flop at every fourth clk1 signal. In the first cycle of CLK1, the first 2nd-order IIR filtering in FIGURE 3 takes place; in the second cycle of CLK1, the second 2nd-order IIR filtering takes place; in the third cycle of CLK1, the third 2nd-order IIR filtering takes place; in the fourth cycle of CLK1, the fourth 1st-order IIR filtering takes place. The output is sampled at the rising edge of CLK2, which is the end of the fourth cycle of CLK1, when the input has gone through all four of the lower-order filters (three second order and one first order). In this way, the circuit of FIGURE 2 is reused and thereby reduces the amount of circuitry required to implement the high-order IIR filter.

Accordingly, a novel parallel structure for an IIR filter is provided which is at least twice as fast as the prior art due to the parallel structure. In addition, the parallel structure is ideal for programmable coefficients. Therefore, a high-order IIR filter can be implemented by reusing a low-order filter on a time sharing basis and, consequently save large amounts of semiconductor area on a semiconductor chip on which the filter is fabricated. Comparing the parallel implementation of the subject invention with the prior art for a seventh-order IIR filter, as an example, the gate count for the subject implementation is 5379 whereas the gate count for the prior art is 10707, thereby providing an approximately 50 percent saving in chip area.

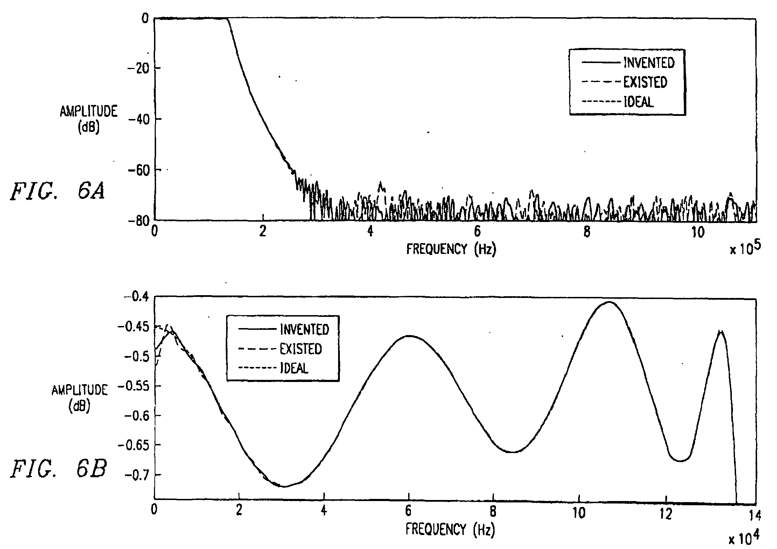

FIGURE 6 is a comparison of the performance of the impulse response between the subject invention and a prior art implementation. The bottom plot shows the zoomed region in the low-frequency region, from which the implementation in accordance with the present invention can be seen to be closer to the ideal response, especially at the DC (frequencies close to zero) region.

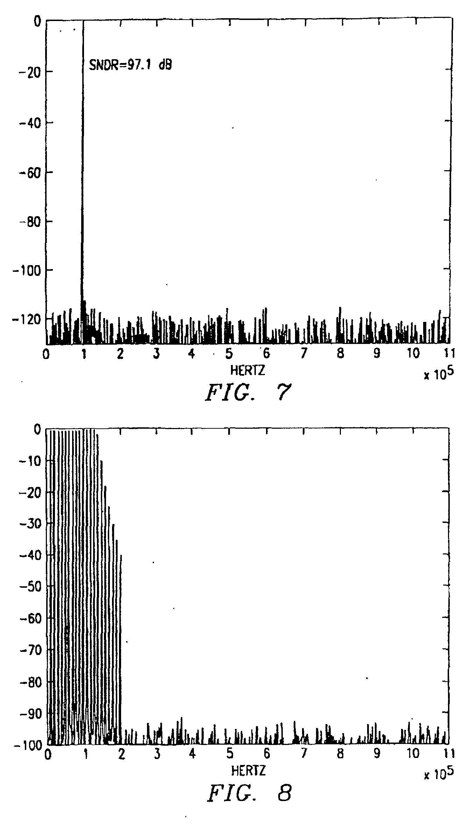

FIGURE 7 is a graph of frequency response of a single tone. A signal-to-noise plus distortion ration (SNDR) of 97.1 dB is achieved. This value is adequately high for a 16-bit register length.

FIGURE 8 is a graph of the frequency response of a discrete multi-tone (DMT). It can be seen that the response shape is as expected.

Though the invention has been described with respect to a specific preferred embodiment thereof, many variations and modifications will immediately become apparent to those skilled in the art.

**Claims**

1. A method of implementing an n-th order IIR filter comprising:

   providing an IIR filter of order less than n; and operating said IIR filter of order less than n on a time-sharing basis a plurality of times such that said plurality of times multiplied by the order of said IIR filter of order less than n is equal to or greater than n.

2. The method of claim 1, wherein said plurality of times multiplied by said order is equal to n.

3. The method of claim 1 or claim 2 further comprising:

   providing a decoder coupled to said input terminal.

4. An n-th order IIR filter comprising:

   an IIR filter of order less than n; and means for operating said IIR filter of order less than n on a time-sharing basis a plurality of times such that said plurality of times multiplied by the order of said IIR filter of order less than n is equal to or greater than n.

5. The filter of claim 5, wherein said plurality of times multiplied by said order is equal to n.

6. The filter of claim 4 or claim 5 further comprising:

   a decoder coupled to said input terminal.

FIG. 1

FIG. 2

FIG. 3

FIG. 4

FIG. 5

6

FIG. 6A

FIG. 6B

SNDR=97.1 dB

HERTZ

x 10^5

FIG. 7

HERTZ

x 10^5

FIG. 8

**European Patent Office**

## EUROPEAN SEARCH REPORT

Application Number

EP 01 00 0566

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 3 706 076 A (SCHUSTER PAUL ALFRED) 12 December 1972 (1972-12-12) * column 2, line 5-55; claim 9 * --- | 1,2,4,5 | H03H17/04 |
| Y | US 5 450 350 A (SAKATA GORO) 12 September 1995 (1995-09-12) * column 10, line 34-60 * ----- | 1,2,4,5 | |

**TECHNICAL FIELDS SEARCHED (Int.Cl.7)**

H03H

The present search report has been drawn up for all claims

| Place of search | Date of completion of the search | Examiner |
|---|---|---|
| THE HAGUE | 11 April 2002 | Coppieters, C |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
 
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 01 00 0566

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2002

| Patent document cited in search report | | | Publication date | Patent family member(s) | | Publication date |
|---|---|---|---|---|---|---|
| US 3706076 | A | | 12-12-1972 | BE | 772813 A1 | 17-01-1972 |
| | | | | CA | 937297 A1 | 20-11-1973 |
| | | | | DE | 2146982 A1 | 13-07-1972 |
| | | | | FR | 2119309 A5 | 04-08-1972 |
| | | | | GB | 1355107 A | 05-06-1974 |
| | | | | IT | 939838 B | 10-02-1973 |
| | | | | JP | 53012145 B | 27-04-1978 |
| | | | | NL | 7112895 A | 23-06-1972 |
| | | | | SE | 364832 B | 04-03-1974 |
| US 5450350 | A | | 12-09-1995 | JP | 3177978 B2 | 18-06-2001 |
| | | | | JP | 4078213 A | 12-03-1992 |
| | | | | US | 5502277 A | 26-03-1996 |
| | | | | US | 5270954 A | 14-12-1993 |

EPO FORM P0459

For more details about this annex : see Official Journal of the European Patent Office, No. 12/82